# EUROPEAN PATENT APPLICATION

(11) **EP 2 433 704 A1**
(43) Date of publication of application: **28.03.2012**
(21) Application number: 11182555.0
(22) Date of filing: 23.09.2011
(51) Int. Cl.: B01D 69/14, B01D 53/22, B01D 53/26, B01D 67/00

(54) **Humidity barrier**

(30) Priority: 27.09.2010 US 386905 P
(71) Applicant: Stichting IMEC Nederland, 5656 AE Eindhoven (NL)
(72) Inventor: Knoben, Wout, 5614 EK Eindhoven (NL); Crego Calama, Mercedes, 5663 PK Geldrop-Mierlo (NL); Brongersma, Sywert, 5644 GK Eindhoven (NL)
(74) Representative: Hertoghe, Kris Angèle Louisa

(57) **Abstract**

A humidity barrier comprises a mixed matrix membrane (10), wherein the mixed matrix membrane (10) comprises a polymer matrix (11) with at least a hydrophobic surface, in which polymer matrix porous hydrophilic filler particles (12) are dispersed. The hydrophobic surface may be formed either by hydrophobic polymer material itself or a hydrophobic coating may be provided on top of non-hydrophobic polymer material.

## Description

### Field of the invention

The present invention relates to a humidity barrier suitable for protecting electronic devices such as electronic circuitry, gas sensors and other devices against humidity such as water and water vapor. The present invention further relates to electronic devices such as electronic circuits and gas sensors comprising such a humidity barrier. The present invention also relates to a method of producing such a humidity barrier.

### Background of the invention

It has been shown that the humidity sensitivity of electronic devices can be reduced by coating them with a thin hydrophobic polymer film (e.g. in Jeyaprakash et al., "A simple route towards the reduction of surface conductivity in gas sensor devices", Sensors and Actuators B 110 (2005) 218-224). The low surface energy of the hydrophobic film reduces adsorption and condensation of water vapor on the surface. Condensation particularly occurs at high humidity levels. However, individual water molecules or water vapor molecules may still penetrate into and pass through the polymer film, even at low humidity levels.

Recently, it has been demonstrated by Choi et al., "Hydrophilic dots on hydrophobic nanopatterned surfaces as a flexible gas barrier" (Langmuir 25 (2009), 7156-7160) that improved humidity barrier properties can be obtained by using a film which has a hydrophobic surface with hydrophilic spots, instead of a purely hydrophobic surface. With such a film, water or water vapor molecules incident upon the hydrophobic regions move along the hydrophobic surface until they reach a hydrophilic spot, which serves as a water collection area. Water molecules are collected on the hydrophilic spots until a macroscopic droplet is formed. While the use of hydrophilic water collection areas may improve the barrier properties, the performance of the film will decrease significantly once the collection areas are saturated with water. The droplets collected at the hydrophilic spots may roll or fall off the surface under the influence of gravity. The hydrophilic areas could also be regenerated or 'emptied' by heating the film and thus desorbing the collected water. However, such regeneration is not desirable in terms of power consumption and long lifetimes (in combination with small batteries). Moreover, the fabrication of these patterned hydrophobic/hydrophilic films is relatively complex and expensive, as it includes depositing SiO₂ hydrophilic dots on a nanopatterned hydrophobic surface fabricated by UV-curable nanoimprinting techniques.

It is known to use mixed matrix membranes (MMMs) in gas separation processes. An MMM consists of a polymer matrix in which filler particles are dispersed. In the known MMMs, the filler particles act as a molecular sieve by blocking larger molecules and allowing the smaller ones to pass. Like other gas separation membranes, MMMs are mostly used in large scale industrial processes such as purification of natural gas and flue gases, hydrogen recovery and oxygen or nitrogen enrichment. In, e.g., US 2009/0126566 an MMM is disclosed which is capable of separating an ethanol-water mixture. The smaller and lighter water molecules can pass through the membrane, while the larger and heavier ethanol molecules are blocked. Although such a membrane is suitable for separating water-ethanol mixtures, it cannot be used as a humidity barrier because it is permeable for water and only blocks the ethanol.

### Object of the invention

It is an object of the present invention to provide a good humidity barrier for electronic components. Compared to prior art solutions, a humidity barrier according to embodiments of the present invention may have an increased capacity for water collection and/or a reduced condensation of water vapor on a surface of the humidity barrier may occur.

### Summary of the invention

The above objective is accomplished by a method and device according to the present invention.

According to a first aspect of the invention, this object is achieved by providing a humidity barrier comprising a mixed matrix membrane, the mixed matrix membrane comprising a polymer matrix with at least a hydrophobic surface, in which polymer matrix porous hydrophilic filler particles are dispersed. The polymer matrix with at least a hydrophobic surface may either consist of hydrophobic material, or may be a polymer matrix comprising hydrophilic material, but being provided, e.g. coated, with a hydrophobic surface.

In contrast with known MMMs, a humidity barrier according to embodiments of the present invention is not a sieve for blocking larger molecules and allowing the smaller ones to pass through the membrane. The operation of a membrane according to embodiments of the present invention is based on the hydrophobic properties of the surface of the polymer matrix and the hydrophilic properties of the embedded porous filler particles. A membrane according to embodiments of the present invention uses the water repellent properties of the hydrophobic surface to reduce adsorption or condensation of water vapor at its surface, while the water collecting properties of the porous hydrophilic filler particles capture the water that still manages to penetrate into the membrane, thereby avoiding that the water passes through the membrane.

Compared to the above described humidity barrier film comprising a hydrophobic surface with hydrophilic spots (Choi et al.), it is an advantage of a humidity barrier according to embodiments of the present invention that the hydrophilic filler particles can be embedded in the polymer matrix with hydrophobic surface, e.g. hydrophobic polymer matrix. The low surface energy of the hydrophobic surface of the humidity barrier reduces adsorption and condensation of water vapor on the surface. Most water flowing along the surface of the humidity barrier may just pass by and will not be adsorbed. In the prior art hydrophobic film with hydrophilic spots, also the water that is just 'passing by' is collected by the hydrophilic spots, which may lead to a fast saturation of the humidity barrier film. In a humidity barrier according to embodiments of the present invention, individual water molecules penetrating into the membrane can be captured by the porous hydrophilic filler particles, such that their passing through the barrier can be avoided.

It is an advantage of a humidity barrier according to embodiments of the present invention that the porous hydrophilic filler particles have an increased available surface for adsorption of water and can collect much larger amounts of water as compared to prior art hydrophilic spots. Furthermore, in a porous medium capillary condensation (i.e. condensation below the saturation vapor pressure) can occur, thus increasing the efficiency of the water collection in a humidity barrier in accordance with embodiments of the present invention. When saturation occurs, the membrane can still be regenerated by desorbing the collected water, for example by heating. The increased capacity to collect water (vapor) reduces the time before such regeneration is needed. The use of a mixed matrix membrane according to embodiments of the present invention therefore offers a longer lifetime of the membrane and possibly reduced power consumption as compared to prior art solutions. An additional advantage of a humidity barrier according to embodiments of the present invention is that the embedded filler particles only adsorb water that has entered the polymer matrix, not water just "passing by".

In embodiments of the present invention, the material of the polymer matrix can be selected such that the humidity barrier can be permeable for at least one predetermined gas. The molecules of the at least one predetermined gas can be larger than the water molecules or they can be smaller than the water molecules, or can be of equal size. As an example, fluoropolymers are known to have a high permeability for CO₂ due to specific molecular interactions.

The polymer matrix may be a hydrophobic polymer matrix, which may, e.g., comprise one or more of the following types of polymers: polyalkylacrylates, polydienes, polyolefins, polysiloxanes, polyvinyls, polystyrenes, fluoropolymers and polycarbonates or any other suitable hydrophobic polymer known to a person skilled in the art. A hydrophobic surface to the polymer matrix may also be obtained by roughening a surface, adding structure to it or covering the surface with a hydrophobic layer, such as e.g. a hydrophobic self-assembled monolayer

The hydrophilic filler particles may for example comprise one or more of the following materials: aluminosilicates such as, e.g., zeolites, metal oxides, metal organic frameworks (MOFs) or organic zeolites, porous glass materials and nanocrystalline silicas, or any other suitable material known to a person skilled in the art.

In a particular embodiment, the polymer matrix is a hydrophobic polymer matrix comprising polytetrafluoroethylene or one of its copolymers and the filler particles comprise aluminosilicates. Fluoropolymers, such as polytetrafluoroethylene, are known for their extremely low surface energy and high hydrophobicity. Zeolites are crystalline porous aluminosilicates.

According to a second aspect of the present invention, a gas sensor is provided for sensing at least one predetermined gas, a sensing surface of the gas sensor at least partially being covered by the humidity barrier according to embodiments of the first aspect of the present invention. The humidity barrier used for this purpose is at least partially permeable for the at least one predetermined gas of interest. This humidity barrier improves the selectivity of the gas sensor by preventing water from reaching the sensing surface, while allowing the gas of interest to pass through the membrane. The sensing surface will thus only respond to the gas of interest and not to water or water vapor.

In a further aspect, the humidity barrier according to embodiments of the present invention may also be used as a protective coating for electronic circuits, which are often sensitive to water or water vapor. Such a protective coating may substantially increase the lifetime of the circuits to which it is applied, such as for example, but not limited thereto, organic electronic circuits. For example, protecting an OLED (Organic Light Emitting Diode) display with a humidity barrier according to embodiments of the present invention may significantly increase the lifetime of the OLED display. When using a humidity barrier according to embodiments of the present invention to protect an OLED display, the humidity barrier is preferably transparent to the light generated by the OLEDs. If the OLEDs are used for lighting purposes only, the transparency of the humidity barrier may be partial. An advantage of the humidity barrier according to embodiments of the present invention as compared to inorganic membranes (e.g. glass or aluminum) for blocking water vapor is its mechanical flexibility. This mechanical flexibility makes the membrane forming the humidity barrier very suitable for use with flexible (e.g. rollable or bendable) electronics.

Further applications of the humidity barrier according to embodiments of the present invention may be in packaging of food or other perishables, in which case the humidity barrier according to embodiments of the present invention could be provided at the inner side or at the outside of the packaging material, or in drying of air and other gas streams, in which case the gas to be dried could be sent either through or over the humidity barrier. A typical application hereof would be sending a wet gas through a tubular membrane. If water cannot penetrate the membrane and the other gas(es) can, dry gas is obtained on the outside of the tube.

According to yet a further aspect of the invention, a method of producing a humidity barrier is provided. The method may comprise a step of mixing a polymer, e.g. a hydrophobic polymer, with porous hydrophilic filler particles to obtain a mixture thereof, and a step of depositing the mixture, e.g. using spin coating or printing (such as ink jet printing), so as to obtain a mixed matrix membrane comprising a polymer matrix in which the porous hydrophilic filler particles are dispersed. If the polymer used is not a hydrophobic polymer, the method according to embodiment of the present invention would further include a step of providing a hydrophobic surface to the polymer matrix, for example by coating the polymer matrix with a hydrophobic layer, or by surface texturing the polymer matrix. Alternatively, the method may comprise depositing alternating hydrophobic polymer comprising layers and porous hydrophilic filler particle comprising layers.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention are apparent from and will be elucidated with reference to the embodiments described hereinafter.

### Brief description of the drawings

FIG. 1 schematically shows a cross section of a humidity barrier according to an embodiment of the invention.
FIG. 2 and FIG. 3 show experimental results illustrating the effectiveness of a humidity barrier according to embodiments of the present invention.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope. In the different drawings, the same reference signs refer to the same or analogous elements.

### Detailed description of the invention

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

It should be noted that the use of particular terminology when describing certain features or aspects of the invention should not be taken to imply that the terminology is being re-defined herein to be restricted to include any specific characteristics of the features or aspects of the invention with which that terminology is associated.

In the context of the present invention, a mixed matrix membrane (MMM) is a hybrid membrane containing fillers dispersed in a polymer matrix. The fillers used in the context of the present invention are hydrophilic particles. A mixed matrix membrane according to embodiments of the present invention comprises at least a hydrophobic surface.

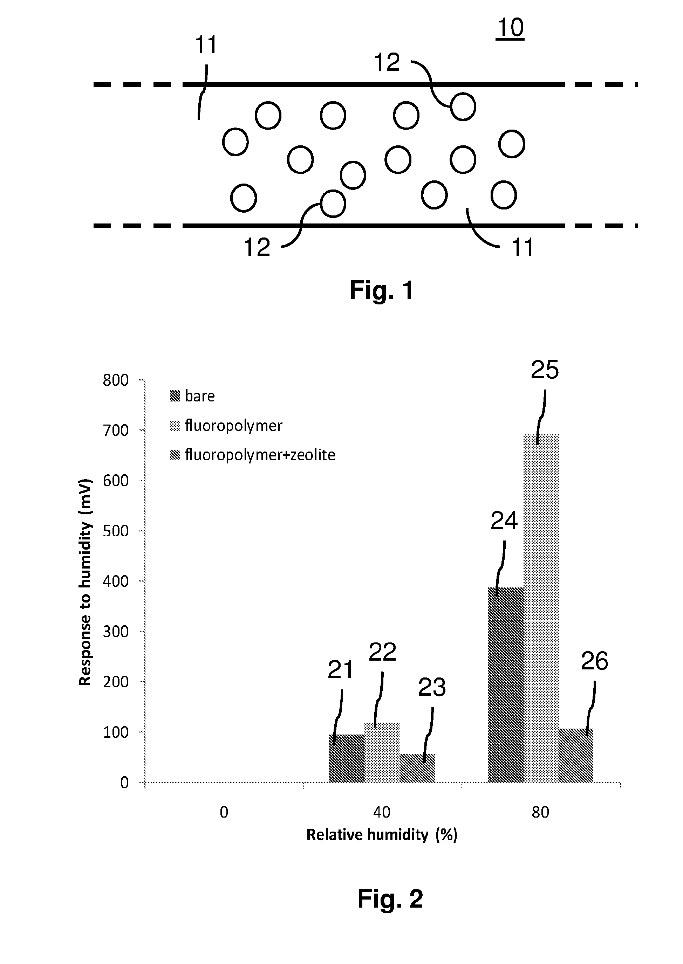

FIG. 1 schematically shows a cross section of a membrane 10 functioning as a humidity barrier according to an embodiment of the present invention. In the embodiment illustrated, the membrane 10 comprises a hydrophobic polymer matrix 11 with dispersed therein porous hydrophilic filler particles 12. In particular embodiments of the present invention, the filler particles 12 are fully embedded in the polymer matrix 11, such that no filler particles reach the surface of the polymer matrix 11. In embodiments of the present invention, this can be obtained by simply spin coating the mixture of polymer matrix and filler material. Optionally, either to make completely sure that no hydrophilic particles reach the surface of the polymer material, or to cover polymer material which may or may not be hydrophobic, the polymer material may be provided with a hydrophobic surface layer. Together, the polymer matrix 11 and filler particles 12 form a mixed matrix membrane (MMM) 10 which, optionally provided with a supplementary hydrophobic surface layer, forms the humidity barrier.

In embodiments of the present invention, the membrane 10 can be permeable to at least one predetermined gas, e.g. through the free volume of the polymer matrix 11.

In known MMMs, smaller and lighter water molecules can pass the membrane, while larger and heavier molecules such as for example carbon dioxide (CO₂), methane (CH₄) or ethanol (C₂H₅OH), are blocked. Although such membranes are suitable for separating, e.g., water-ethanol mixtures, they cannot be used as a humidity barrier because they are permeable for water and only block molecules that are larger than water molecules.

In a MMM 10 according to embodiments of the present invention, the water molecules are blocked from passing through the membrane while gas molecules, possibly larger than the water molecules, can pass the membrane 10. This is possible because the hydrophobic surface of the polymer matrix 11, either the surface of the polymer matrix itself of a supplementary hydrophobic layer provided on top thereof, repels the water molecules, but not the gas molecules. The gas molecules, even if larger than the water molecules, can normally pass the membrane 10 through the free volume of the polymer matrix 11. If, despite the hydrophobic properties of the surface of the polymer matrix 11, a water molecule enters the membrane 10, the porous and hydrophilic filler particles 12 capture the water molecule. Without the filler particles 12, a water (vapor) molecule entering the membrane 10 has a higher probability of passing through the membrane 10. Consequently, in accordance with embodiments of the present invention, water and water vapor are blocked, while the membrane 10 is permeable for gas molecules that are small enough to pass the polymer matrix 11.

The above described properties make the MMM 10 very suitable for use in gas sensors. Gas sensors are often sensitive to water vapor. When coated with an MMM 10 according to embodiments of the present invention, for example as shown in FIG. 1, no (or very little) water will reach the gas sensor while the gas to be sensed can freely pass the coating formed by the membrane 10. Other applications for the humidity barrier of FIG. 1 are, e.g., packaging of food or other perishables, drying of air and other gas streams or water protective coatings for electronic circuits. The flexibility of the materials used for a humidity barrier according to embodiments of the present invention make it very suitable for coating flexible electronic circuits, such as rollable OLED displays. Organic materials are most often more suitable to be used as polymer materials in the context of the present invention because they inherently comprise pores allowing gas to pass. Most inorganic materials will block everything.

The polymer matrix 11 may, e.g., comprise one or more of the following types of polymers: polyalkylacrylates, polydienes, polyolefins, polysiloxanes, polyvinyls, polystyrenes, fluoropolymers and polycarbonates. Aluminosilicates such as, e.g., zeolites, metal oxides, metal organic frameworks or organic zeolites, porous glass materials and nanocrystalline silicas are suitable materials for use as filler particles 12. The membrane 10 may comprise a mixture of different filler particles 12A particular embodiment uses polytetrafluoroethylene or one of its copolymers for the polymer matrix 11 and aluminosilicates for the filler particles 12. A homogeneous distribution of filler particles in the polymer matrix is preferred since this provides the highest surface area for trapping water molecules. However, some clustering of particles does not need to be detrimental. The concentration of the filler particles in the polymer matrix may be optimized: more filler particles give a higher capacity for water capture, but too many filler particles may compromise the mechanical properties of the humidity barrier according to embodiments of the present invention or may lead to particles sticking out the membrane, hence attracting water molecules to the membrane rather than repelling them.

The humidity barrier is preferably produced by mixing the polymer with the filler particles 12 and depositing the mixture, e.g., using spin coating or printing, so as to form the membrane 10. Alternatively, the materials are not mixed before the deposition, but alternating layers of polymer and filler particles are deposited (at least one layer of each).

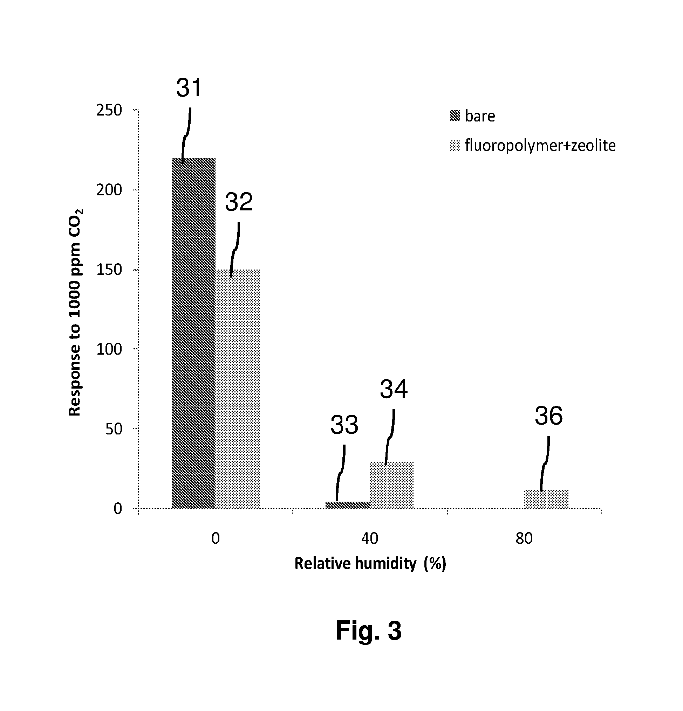

FIG. 2 and FIG. 3 show experimental results illustrating the effectiveness of a humidity barrier according to embodiments of the present invention. In the presented experiments, a gas sensor is exposed to different controlled air mixtures at different humidity levels. FIG. 2 shows sensor response (y-axis) to different humidity levels (x-axis) in synthetic air. In this experiment, the sensor response 21, 24 of a bare gas sensor (without humidity barrier in accordance with embodiments of the present invention) is compared to the response 22, 25 of gas sensors with a purely hydrophobic humidity barrier and to the response 23, 26 of gas sensors with a humidity barrier according to embodiments of the present invention comprising a fluoropolymer matrix with dispersed zeolite particles. The pure hydrophobic humidity barrier consists of a fluoropolymer. The humidity barrier according to the invention is a fluoropolymer matrix membrane with zeolite filler particles.

At 0% relative humidity, none of the gas sensors shows any response. Both at 40 and 80% relative humidity, the fluoropolymer+zeolite humidity barrier according to embodiments of the present invention shows the best performance (gas sensor shows least response to humidity) compared to a bare sensor (no barrier film) and a sensor coated with a pure fluoropolymer film. It may thus be concluded that the humidity barrier according to embodiments of the present invention reduces the sensitivity of the gas sensor to water (vapor).

FIG. 3 shows, as an example, sensor response (y-axis) to 1000 ppm CO₂ (an example of a gas of interest) in synthetic air at different humidity levels (x-axis). A bare sensor, without any humidity barrier, shows the largest response under dry conditions, see graph 31, but in the presence of water vapor the response (graph 33 at 40% relative humidity, no response at 80% relative humidity) to CO₂ is strongly decreased and does no longer constitute a significant measurement. The signal in graph 33 is so low it can hardly be distinguished from the noise of the measurement. The sensor coated with a fluoropolymer+zeolite humidity barrier film in accordance with embodiments of the present invention shows a lower response - graph 32 - under dry conditions, and still shows significant response to CO₂ at 40% relative humidity (graph 34) and even at 80% relative humidity (graph 36).

It should be noted that the above-mentioned embodiments illustrate rather than limit the invention, and that those skilled in the art will be able to design many alternative embodiments without departing from the scope of the appended claims. Use of the verb "comprise" and its conjugations does not exclude the presence of elements or steps other than those stated in a claim. The article "a" or "an" preceding an element does not exclude the presence of a plurality of such elements. The mere fact that certain measures are recited in mutually different dependent claims does not indicate that a combination of these measures cannot be used to advantage.

## Claims

1. A humidity barrier comprising a mixed matrix membrane (10), wherein the mixed matrix membrane (10) comprises a polymer matrix (11) with at least a hydrophobic surface, in which polymer matrix porous hydrophilic filler particles (12) are dispersed.

2. A humidity barrier according to claim 1, wherein the filler particles (12) are fully embedded in the polymer matrix (11).

3. A humidity barrier according to any of the previous claims, wherein the filler particles (12) are made from any of the following materials: aluminosilicates, zeolites, metal oxides, metal organic frameworks, porous glass materials and nanocrystalline silicas.

4. A humidity barrier according to any of the previous claims, wherein the polymer matrix is a hydrophobic polymer matrix.

5. A humidity barrier according to claim 4, wherein the hydrophobic polymer matrix (11) comprises at least one of the following types of polymers: polyalkylacrylates, polydienes, polyolefins, polysiloxanes, polyvinyls, polystyrenes, fluoropolymers and polycarbonates.

6. A humidity barrier according to any of claims 4 or 5, wherein the hydrophobic polymer matrix (11) comprises polytetrafluoroethylene and wherein the filler particles (12) comprise aluminosilicates.

7. A humidity barrier according to any of the previous claims, wherein the polymer matrix is provided with a hydrophobic cover layer.

8. A humidity barrier according to any of the previous claims, wherein the material of the polymer matrix is selected such that the humidity barrier is permeable for at least one predetermined gas.

9. A gas sensor comprising a sensing surface for sensing a predetermined gas, which is at least partially covered by a humidity barrier according to claim 8.

10. An electronic circuit with a protective coating, the protective coating comprising a humidity barrier according to any of claims 1 to 8.

11. An electronic circuit according to claim 10, wherein the electronic circuit comprises organic electronics.

12. An electronic circuit according to claim 11, wherein the electronic circuit is part of an OLED display.

13. A method of producing a humidity barrier, the method comprising:
- mixing a polymer with porous hydrophilic filler particles (12) to obtain a mixture thereof,
- depositing the mixture so as to obtain a mixed matrix membrane (10) comprising a polymer matrix (11) in which the porous hydrophilic filler particles (12) are dispersed, and
- if the polymer is not hydrophobic, providing the mixed matrix membrane (10) with a hydrophobic coating so as to form a hydrophobic surface to the humidity barrier.

14. A method according to claim 13, furthermore comprising providing a hydrophobic coating on the mixed matrix membrane (10).

15. Use of a mixed matrix membrane (10) comprising a hydrophobic polymer matrix (11) in which porous hydrophilic filler particles (12) are dispersed, as a humidity barrier.
